(19) **Europäisches Patentamt**
**European Patent Office**
**Office européen des brevets**

(11) **EP 1 384 303 B1**

(12) **EUROPÄISCHE PATENTSCHRIFT**

(45) Veröffentlichungstag und Bekanntmachung des Hinweises auf die Patenterteilung:
**24.06.2009 Patentblatt 2009/26**

(21) Anmeldenummer: **02706501.0**

(22) Anmeldetag: **11.03.2002**

(51) Int Cl.:
*H02J 1/14* (2006.01)   *H03K 17/82* (2006.01)

(86) Internationale Anmeldenummer:
**PCT/AT2002/000079**

(87) Internationale Veröffentlichungsnummer:
**WO 2002/082611 (17.10.2002 Gazette 2002/42)**

(54) **STROMVERSORGUNG MIT ABSCHALTSICHERUNG**

ELECTRIC POWER SUPPLY WITH A SAFETY CUT-OFF

ALIMENTATION EN COURANT AVEC SECURITE COUPE-CIRCUIT

(84) Benannte Vertragsstaaten:
**AT CH DE IT LI**

(30) Priorität: **06.04.2001 AT 5602001**

(43) Veröffentlichungstag der Anmeldung:
**28.01.2004 Patentblatt 2004/05**

(73) Patentinhaber: **Siemens AG Österreich**
**1210 Wien (AT)**

(72) Erfinder:
• **HALLAK, Jalal**
**A-1220 Wien (AT)**

• **SCHWEIGERT, Harald**
**A-1120 Wien (AT)**

(74) Vertreter: **Maier, Daniel Oliver et al**
**Siemens AG**
**Postfach 22 16 34**
**80506 München (DE)**

(56) Entgegenhaltungen:
**DE-U- 29 909 206      US-A- 5 969 514**
**US-A- 6 157 089**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung bezieht sich auf eine Stromversorgung, bei welcher eine Speisespannung über zumindest einen Längszweig zu zumindest einem Ausgang geführt ist, wobei der zumindest eine Zweig eine als gesteuerten Halbleiterschalter ausgebildete Abschaltsicherung aufweist und eine Überwachungseinheit dazu eingerichtet ist, bei Änderungen von Spannungen oder Strömen über vorgebbare Toleranzwerte an den Halbleiterschalter ein Abschaltsignal zu liefern.

In Industrieanlagen und in automatisierten Anlagen, ist es von besonderer Bedeutung, dass die Speisespannungen den einzelnen Verbrauchern oder Verbrauchergruppen nach besonderen Sicherheitskriterien zugeführt werden. Insbesondere müssen informationsverarbeitende Teile eines Steuerungssystems, z. B. Mikroprozessorbaugruppen im Fehlerfall vorrangig mit der benötigten Energie versorgt werden. Bei vielen Industrieanwendungen beträgt die Speisespannung 24-Volt-Gleichspannung, doch sind auch andere Gleichspannungswerte üblich und auch Wechselspannungen, z. B. 115, 230 oder 24 Volt, in Verwendung.

Bei Kurzschlüssen oder Überlasten in Teilbereichen eines Steuerungssystems, z. B. in der Ausgabeperipherie, kann es leicht zu einem, meist zwar nur kurzen Gesamtausfall der Speisespannung des Steuerungssystems kommen, was oft zu einem Datenverlust in den von der Speisespannung versorgten zentralen Steuerungseinheiten führt.

Der zunehmende Einsatz von Schaltnetzteilen, d. h. getakteter Stromversorgungen, aktualisiert dieses Problem, da wegen der empfindlichen Elektronik die internen Regelkreise den Ausgangsstrom auf Werte begrenzen, welche nur geringfügig über dem Nennstrom liegen. Insbesondere besteht das Problem, dass übliche Sicherungen für die einzelnen Ausgänge nicht in ausreichend kurzer Zeit abschalten können. Zum raschen Abschalten benötigen Sicherungen oder Leistungsschutzschalter oft ein Vielfaches ihres Nennstromes. Diesen können die Schaltnetzteile jedoch nicht zusätzlich zu der übrigen Last liefern, sodass die gesamte Speisespannung einbricht - noch bevor eine Sicherung auslöst und der fehlerhafte Ausgang bzw. Zweig weggeschaltet wird.

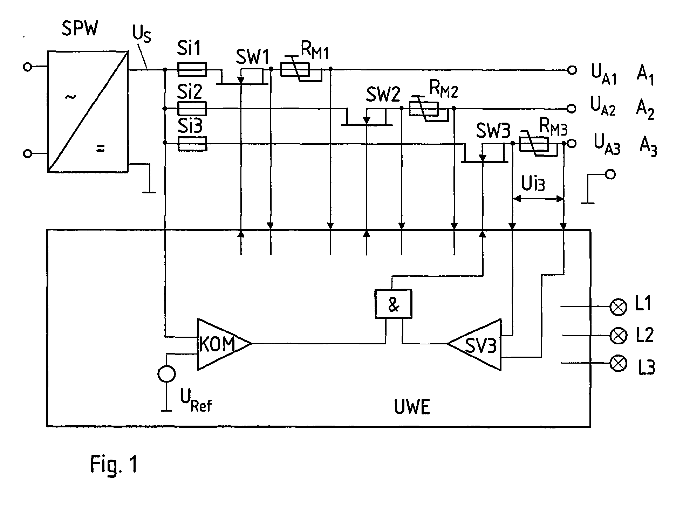

Gemäß der älteren Anmeldung PCT/AT 00/00318 der Anmelderin wird daher die eingangs erwähnte Verwendung von gesteuerten Halbleiterschaltern vorgesehen. Eine derartige Schaltung ist nachstehend anhand der Fig.1 erläutert.

Gemäß Fig. 1 liefert ein getakteter Spannungswandler SPW eine Ausgangs- oder Speisespannung Us, beispielsweise 24 Volt, gegen Masse. Solche Spannungswandler oder Schaltnetzteile sind dem Fachmann in einer Vielzahl von Ausführungen bekannt und bilden an sich nicht den Gegenstand der Erfindung. Meist wird eine Eingangswechselspannung, z. B. 230 Volt, gleichgerichtet und die entstehende Gleichspannung wird über einen getakteten Schalter einer Primärwicklung eines Transformators zugeführt. Sekundärseitig erfolgt wieder eine Gleichrichtung auf die Speisespannung. Der Spannungswandler SPW arbeitet beispielsweise als Sperr- oder Flusswandler und ist meist auf konstante Ausgangsspannung geregelt. Es soll aber betont werden, dass die Erfindung nicht auf bestimmte Wandler eingeschränkt ist und dass die Speisespannung beispielsweise auch eine geregelte oder ungeregelte Wechselspannung sein kann.

Die Speisespannung $U_s$ ist einem ersten Ausgang $A_1$ über eine herkömmliche Sicherung Si1, einen gesteuerten Schalter SW1 und über einen Messwiderstand $R_{M1}$ zugeführt. An dem Ausgang $A_1$ liege die Ausgangsspannung $U_{A1}$. In gleicher Weise ist die Speisespannung $U_s$ einem Ausgang $A_2$ sowie einem Ausgang $A_3$ zugeführt. Die Sicherungen $S_i1$ - $S_i3$ sind z. B. Schmelzsicherungen und sind vor allem dann vorgesehen, wenn dies übliche Sicherheitsbestimmungen, vor allem hinsichtlich des Brandschutzes, verlangen. Für die Funktion der Erfindung sind sie jedoch ohne Belang.

Einer Überwachungseinheit UWE ist einerseits die Speisespannung Us zugeführt, die in einem Komparator KOM mit einer Referenzspannung $U_{Ref}$ verglichen wird, andererseits jede der an den Messwiderständen auftretenden, den Ausgangsströmen proportionalen Spannungen, z. B. $V_{i3}$, zum Vergleich in Schaltverstärkern, z. B. $SV_3$. Die gezeigte Schaltung ermöglicht, verbunden mit einer hier nicht gezeigten Folgesteuerung, ein selektives Abschalten von Ausgängen bei Einbrüchen der Speisespannung, entsprechend vorgegebenen Prioritäten, bzw. ein Abschalten einzelner Zweige bei Überstrom. Es ist auch möglich, zusätzlich oder alternativ die Ausgangsspannungen $U_{A1}$ ... $U_{A3}$ zu überwachen und für Abschaltvorgänge heranzuziehen. Der jeweilige Schaltzustand kann z. B. durch Lämpchen L1 ... L3 angezeigt werden.

Im normalen Betrieb befindet sich ein Schalttransistor eines Längszweiges in einem Betriebszustand, in dem ein nur geringer Spannungsabfall an ihm auftritt, d. h. der Transistor befindet sich in der Sättigung mit einer Längsspannung von z. B. deutlich unter einem Volt. Entsprechend ist die Verlustleistung des Transistors nicht allzu groß. Auf eine solche Dauerverlustleitung ist auch die Kühlung ausgelegt.

Falls nun der eingestellte Grenzstrom überschritten wird, beginnt der Transistor - zusammen mit der Überwachungsschaltung - den Ausgangsstrom konstant zu halten, um die Speisequelle nicht zu sehr zu belasten und damit einen Absturz des Gesamtsystems zu provozieren. Der Sättigungszustand wird verlassen und dadurch wird nun eine hohe Verlustleistung in dem Transistor umgesetzt, nämlich im Extremfall der Kurzschlussstrom mal Speisespannung. Da der Transistor, z. B. vom MOSFET-Typ, bereits im Normalbetrieb erwärmt wurde, ist die Aufnahme der zusätzlichen Verlustleistung im Begrenzungszustand problematisch. Dazu kommt, dass der Begrenzungszustand eine kurze Zeitspanne, beispielsweise 50 - 100 ms, andauert, dann tritt das Abschalten ein. In dieser kurzen Zeit kann die Wärme gar nicht an einen Kühlkörper weitergeleitet werden und muss daher von dem Transistor-Chip aufgenommen werden. Um eine Zerstörung des Schalttransistors vor dem Abschalten zu vermeiden, müssen daher Transistoren mit sehr großen Chipflächen eingesetzt werden, was zu hohen Kosten führt.

Eine ähnliche Schaltung geht auch aus der DE 299 09 206 U1 hervor, das eine Schutzeinrichtung eines Niedervolt-Stromverteilungssystems beschreibt, bei welchem jedem Stromkreis ein eigener Schutzschalter mit einstellbarer Strombegrenzung als Kurzschluss- und/ oder Überlastschutz zugeordnet ist. Die Abschaltzeit der einzelnen Schalter kann über die Längsspannung an diesen Schaltern beeinflusst werden.

Das Dokument US 5 969 514 beschreibt einen Tiefsetzsteller, bei welchem der sonst übliche einzige Schalttransistor durch mit Drain und Source parallel geschaltete Transistoren realisiert wird, die in Abhängigkeit von der Höhe der Ausgangsspannung eingesetzt werden bzw. nicht eingesetzt oder angesteuert werden. Hier liegen ständig getaktete Schalttransistoren vor, nicht jedoch ist die Problematik einer Abschaltsicherung, die im Prinzip nur ein- oder ausgeschaltet ist gegeben.

Eine Aufgabe der Erfindung liegt somit in der Schaffung einer Stromversorgung, bei welcher die Problematik einer teuren Überdimensionierung des Halbleiterschalters nicht mehr gegeben ist.

Diese Aufgabe wird, ausgehend von einer Stromversorgung der eingangs genannten Art erfindungsgemäß dadurch gelöst, dass dem Halbleiterschalter zumindest ein, gleichfalls von der Überwachungseinheit angesteuerter Hilfs-Halbleiterschalter parallel geschaltet ist, welcher im Überlastfall einen wesentlichen Anteil des Überlaststromes in dem Zweig übernimmt.

Dank der Erfindung wird somit der thermische "Stoss" vor dem Abschalten kurzfristig auf den Hilfstransistor übergeleitet, der zu diesem Zweck ohne die erwähnte Grunderwärmung zur Verfügung steht.

Bei einer zweckmäßigen Variante ist vorgesehen, dass die Überwachungseinheit dazu eingerichtet ist, den Hilfs-Halbleiterschalter im Normalbetrieb zumindest im wesentlichen ausgeschaltet zu halten, im Überlastfall, bei gleichzeitigem Abschalten des Haupt-Halbleiterschalters, jedoch einzuschalten. Auf diese Weise kann durch geeignete Auslegung der Überwachungseinheit die Charakteristik des Überganges von dem Hauptschalter auf den Hilfsschalter beeinflusst werden.

Besonders vorteilhaft ist es, wenn in Serie mit dem Hilfs-Halbleiterschalter ein Ballastwiderstand geschaltet ist. Dadurch wird der größte Teil der Wärme in dem Ballastwiderstand umgesetzt und der Hilfs-Halbleiterschalter kann auf eine geringere Verlustleistung dimensioniert werden und daher billiger sein. Dabei ist es empfehlenswert, wenn der vorgebbare Kurzschlussstrom des Zweiges im wesentlichen durch den Ballastwiderstand und die Speisespannung bestimmt ist, sodass $R1A \approx U_s/I_{K1}$.

In der Praxis ist es zweckmäßig und kostengünstig, falls die Halbleiterschalter vom FET-Typ sind. Auf diese Weise kann die Ansteuerung durch die Überwachungseinheit vereinfacht werden. Dabei ergibt sich schaltungstechnisch eine besonders einfache Lösung, wenn die Halbleiterschalter vom selbstsperrenden FET-Typ sind, wobei das Gate des Haupt-Halbleiterschalters mit der Source verbunden und von einem Ausgang der Überwachungseinheit über eine Zenerdiode und das Gate des Hilfs-Halbleiterschalters von dem selben Ausgang direkt angesteuert ist. Zur Aufnahme der im Abschaltfall auftretenden Leistungsimpulse eignet sich besonders ein Ballastwiderstand, der als Massewiderstand ausgebildet ist.

Die Erfindung bezieht sich auf eine Stromversorgung gemäss Anspruch 1.

Die Erfindung samt weiteren Vorteilen ist im folgenden anhand beispielsweiser Ausführungsformen näher erläutert, die in der Zeichnung veranschaulicht sind. In dieser zeigen

■ Fig.1 eine weiter oben bereits beschriebene Schaltung einer Spannungsversorgung gemäß der älteren Anmeldung PCT/AT 00/00318,

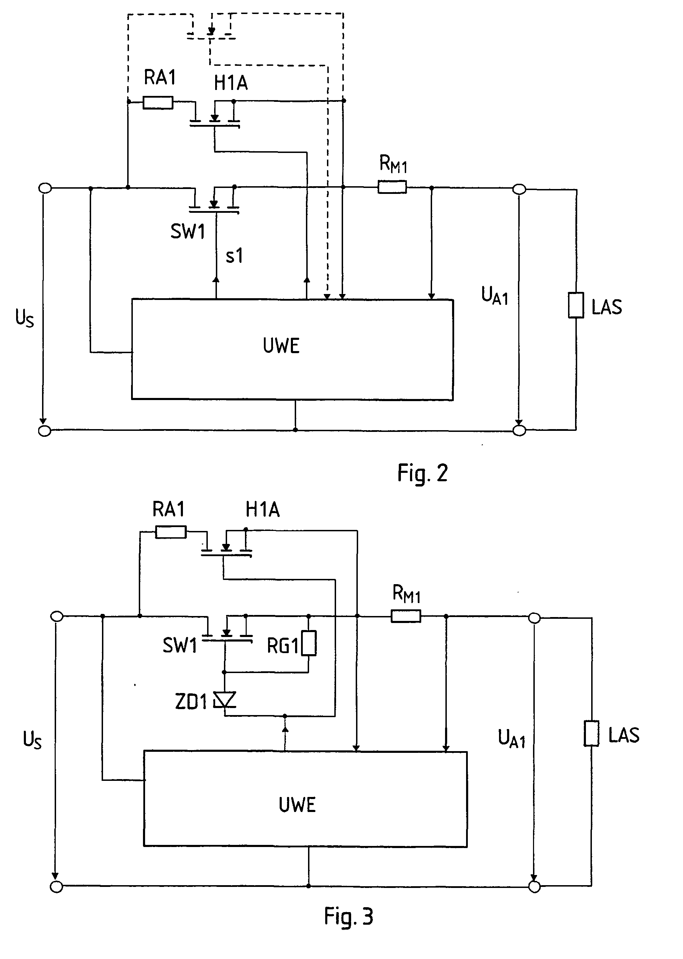

■ Fig. 2 eine Schaltung einer ersten Ausführungsform der Erfindung, und

■ Fig. 3 eine Schaltung einer zweiten Ausführungsform der Erfindung.

Gemäß Fig. 2, welche lediglich einen Zweig einer Schaltung nach Fig.1 betrifft, liegt die Last LAS über einen Halbleiterschalter SW1, hier ein selbstsperrender n-Kanal-IGFET, an der Speisespannung $U_s$. Wie bereits im Zusammenhang mit Fig. 1 erläutert, sorgt eine Überwachungseinheit UWE durch ein entsprechendes Signal an das Gate des Schalters SW1 für dessen Öffnen, falls z. B. der mit Hilfe des Widerstandes $R_{M1}$ gemessene Strom einen vorgebbaren Maximalwert überschreitet. Varianten der Abschaltbedingungen sind möglich, z. B. ein Abschalten in Abhängigkeit von der Ausgangsspannung oder der Eingangsspannung sowie Kombinationen solcher Abschaltbedingungen.

Die Grundfunktion einer solchen elektronischen Sicherung ist es zu verhindern, dass durch einen Zweig der Schaltung ein beliebig großer Strom fließen kann. De facto ist dies die übliche Funktion eines Leitungsschutzschalters mit der zusätzlichen Eigenschaft, dass vor dem vollständigen Unterbrechen der Stromzufuhr noch ein Betriebszustand der Strombegrenzung eingenommen wird.

Eine Anlage mit mehreren Lastzweigen, die über eine derartige elektronische Sicherung versorgt werden, ist vor einem Einbrechen der gesamten Versorgungsspannung auf diese Weise gesichert.

Wie erwähnt, kann beispielsweise als Reaktion auf ein Sinken der Speisespannung $U_s$, z. B. 24 V ein Abschalten der einzelnen Zweige nach einer vorgegebenen Reihenfolge durchgeführt werden.

Zusätzlich kann man auch vorsehen, dass bei Unterschreiten eines bestimmten Wertes der Speisespannung, z. B. 22 V, jener Ausgang oder jene Ausgänge abgeschaltet werden, die zu diesem Zeitpunkt des Unterschreitens mehr als 100 % des eingestellten Sollstroms führen.

Die Erfindung sieht nun vor, dass dem Halbleiterschalter SW1 ein Hilfs-Halbleiterschalter H1A parallel geschaltet st, im vorliegenden Fall der Fig. 2 gleichfalls ein selbstsperrender n-Kanal Feldeffekttransistor. Hier liegt in Serie mit dem Hilfsschalter H1A noch ein Ballastwiderstand RA1, der jedoch, wie noch zu erläutern ist, auch entfallen kann.

Im Normalbetrieb ist der Schalter SW1 leitend und der gesamte Strom fließt im wesentlichen über den Schalter SW1 und über den Messwiderstand $R_{M1}$ in die Last LAS'. Im Falle eines Kurzschlusses, kurzschlusähnlichen Zustandes oder ganz allgemein bei Überschreiten des vorgebbaren Maximalstroms würde bis zu dem Abschalten, wofür z. B. eine Zeitdauer von 50 - 100 ms vorgesehen sein kann, der entsprechend hohe Strom fließen. Um ein Zerstören des im Normalbetrieb bereits erwärmten Schalters SW1 zu vermeiden, wird bei Überlast der Transistor SW1 gesperrt und der Strom fließt nun über den Hilfsschalter H1A und den Ballastwiderstand RA1, bis auch der Hilfsschalter H1A ein Abschalt(Sperr-)signal seitens der Überwachungseinheit UWE erhält.

Davon ausgehend, dass der Ballastwiderstand RA1 einen vergleichsweise höheren Widerstandswert aufweist, als der Durchlasswiderstand der Schalter H1A und SW1, wird die wesentliche Energie bis zum Abschalten in dem Ballastwiderstand RA1 vernichtet. Dadurch ist nicht nur der Hauptschalter SW1 vor thermischer Zerstörung gesichert - es wurde bereits abgeschaltet -, sondern auch der Hilfsschalter H1A.

Der Widerstand RA1 ermöglicht es auch, eine geeignete Dimensionierung vorausgesetzt, dass auch der Hilfsschalter H1A im Normalbetrieb ständig eingeschaltet bleiben kann. Dieser Fall liegt jedenfalls dann vor, wenn die Serienschaltung Ballastwiderstand RA1 - Hilfsschalter H1A (eingeschaltet) einen Widerstandswert aufweist, der groß ist gegen den Durchlasswiderstand des Hauptschalters SW1. In der Praxis wurden z. B. im Strombegrenzungsfall ca. 80 % der anfallenden Verlustleistung in dem Ballastwiderstand RA1 vernichtet.

Bei einem Ausführungsbeispiel beträgt die Speisespannung 24 V, der maximale Kurzschlussstrom 13 A. Der Gesamtwiderstand des Hilfszweiges ergibt sich dann als

$$R_{ges} = \frac{24V}{13A} = 1,84 \ Ohm$$

Der Widerstand des Hilfsschalters $R_{on}$ betrage z. B. 0,1 Ohm, so dass sich der Ballastwiderstand RA1 zu 1,74 Ohm ergibt. Für den Hauptschalter SW1, welcher den Dauerstrom führen muss, wird beispielsweise ein teurerer Transistor mit einem Wert $R_{on}$ von z. B. 5 mOhm gewählt. Besonders zweckmäßig ist ein Massewiderstand, z. B. ein Kohlemassewiderstand, da ein solcher, bezogen auf die Impulsleistung, wesentlich leistungsfähiger ist, als ein Schicht- oder Drahtwiderstand.

In Fig. 2 ist strichliert ein weiterer FET-Schalter angedeutet, welcher parallel zu dem Hauptschalter SW1 liegt. Damit soll zweierlei zum Ausdruck gebracht werden:

Erstens können ein solcher Hilfsschalter H1B zusätzlich zu dem Hauptschalter SW1 und dem Hilfsschalter H1A vorgesehen sein, gegebenenfalls mit einem nicht gezeigten Serien-Ballastwiderstand, um sequentiell mit dem Hilfsschalter H1A oder parallel mit diesem den Stromstoss samt Joul'scher Wärme aufzufangen.

Zweitens könnte ein solcher Hilfsschalter H1B ohne Ballastwiderstand an Stelle der Serienschaltung R1A - H1A eingesetzt werden, damit der Hilfsschalter H1B bei Abschalten des Hauptschalters SW1 den Strom/Wärmestoß aufnehmen kann. Zu diesem Zweck sind der Hauptschalter SW1 und der Hilfsschalter H1B durch die Überwachungsschaltung UWE so anzusteuern, dass im Überlastfall sofort der Hilfsschalter H1B eingeschaltet und der Hauptschalter SW1 ausgeschaltet werden.

Die Variante gemäß Fig. 3 stellt eine besonders einfache Möglichkeit für eine automatische Ansteuerung von zwei parallelen Schaltern, nämlich dem Hauptschalter SW1 und dem Hilfsschalter H1A unter Verwendung einer Zenerdiode dar, wobei die Schaltung im übrigen vollständig jener nach Fig. 2 entspricht.

Eine solche Schaltung ist besonders dann angezeigt, wenn der Hilfeschalter einen wesentlich höheren Innenwiderstand besitzt, als der Hauptschalter, z. B. $R_{on}$ = 5 mOhm für den Hauptschalter und $R_{on}$ = 100 mOhm für den Hilfsschalter.

Die Überwachungseinheit UWE weist beispielsweise eine Operationsverstärkerschaltung mit einem PI-Reglerverhalten auf, sodass sie wie die Ansteuerung einer elektronischen Stromquelle wirkt. Solange der Begrenzungsstrom noch nicht erreicht ist, versucht die Überwachungseinheit bzw. deren Operationsverstärker, den Begrenzungsstrom noch weiter zu erhöhen, in dem die Gatespannung der Schalter bzw. Transistoren SW1, H1A weiter erhöht wird.

Da der Ausgangsstrom der Spannungsversorgung durch die angeschlossene Last LAS bestimmt wird, wird der Ausgang des erwähnten Operationsverstärkers im normalen Betrieb in der positiven Sättigung verharren, z. B. bei 15 Volt. Bei Überschreiten des eingestellten Begrenzungsstroms, dies können z. B. 130 % des mit einem Potentiometer auf einer Skala eingestellten Nennstroms sein, wird der Operationsverstärker aktiv und die Überwachungseinheit UWE senkt nun ihr Ausgangssignal, nämlich die Gatespannung der MOSFET-Transistoren SW1, H1A ab, um den Ausgangsstrom nicht weiter steigen zu lassen.

Wie ersichtlich, ist der Ausgang der Überwachungsschaltung UWE mit dem Gate des Hilfsschalters H1A direkt und mit dem Gate des Hauptschalters SW1 über eine Zenerdiode ZD1 verbunden. Die Gatespannung des Hauptschalters erreicht nun wegen der Zenerdiode die Schwellspannung früher, d. i. jene Spannung, ab welcher ein FET mit nur geringfügig sinkender Gatespannung bereits signifikant hochohmiger wird, d. h. der Beginn des linearen Betriebsfalls, in welchem der Transistor wie ein veränderbarer Widerstand wirkt. Auf diese Weise ist sichergestellt, dass der Hilfstransistor H1A im Begrenzungsfall immer so viel Strom von dem Hauptschalter SW1 übernimmt, wie sie eigener Innenwiderstand und der in Serie geschaltete Ballastwiderstand RA1 erlauben.

Im normalen Dauerbetrieb ist die von der Überwachungseinheit UWE erzeugte Steuerspannung, d. h. die den Gates der Schalter zugeführte Spannung, so zu dimensionieren, dass der Hauptschalter SW1 voll durchgeschaltet werden kann, der Hilfsschalter H1A aber nicht zerstört wird. In der Praxis erhält man eine günstige Dimensionierung, wenn die Zenerspannung der Diode ZD1 etwa der Schwellspannung der verwendeten Transistoren, hier der MOSFET-Transistoren, entspricht, d. h. ca. 3 Volt beträgt.

Der Integralanteil der Regelcharakteristik der Überwachungseinheit UWE ist auch zweckmäßig, um den Unstetigkeitspunkt beim Überwinden der Zenerdiodenschwelle ohne zu große Abweichungen der Ausgangsspannung UA1 zu kompensieren.

## Patentansprüche

1. Stromversorgung, bei welcher eine Speisespannung ($U_s$) über zumindest einen Längszweig zu zumindest einem Ausgang geführt ist, wobei der zumindest eine Zweig eine als gesteuerten Halbleiterschalter (SW1) ausgebildete Abschaltsicherung aufweist und eine Überwachungseinheit (UWE) dazu eingerichtet ist, bei Änderungen von Spannungen oder Strömen über vorgebbare Toleranzwerte an den Halbleiterschalter ein Abschaltesignal (s1) zu liefern,
   **dadurch gekennzeichnet, dass**
   dem Halbleiterschalter (SW1) zumindest eine Serienschaltung eines, gleichfalls von der Überwachungseinheit (UWE) angesteuerten Hilfs-Halbleiterschalter (H1A) und eines Ballastwiderstandes (R1A) parallel geschaltet ist, wobei im Überlastfall die Gatespannung des Halbleiterschalters (SW1) reduziert wird, sodass dieser die Sättigung verlässt, und der Hilfs-Halbleiterschalter (H1A) einen wesentlichen Anteil des Überlaststromes in dem Zweig übernimmt.

2. Stromversorgung nach Anspruch 1, **dadurch gekennzeichnet, dass** die Überwachungseinheit (UWE) dazu eingerichtet ist, den Hilfs-Halbleiterschalter (H1A) im Normalbetrieb zumindest im wesentlichen ausgeschaltet zu halten, im Überlastfall, bei gleichzeitigem Abschalten des Haupt-Halbleiterschalters (SW1), jedoch einzuschalten.

3. Stromversorgung nach Anspruch 1 oder 2, **dadurch gekennzeichnet, dass** der vorgebbare Kurzschlussstrom ($I_{K1}$) des Zweiges im wesentlichen durch den Ballastwiderstand (R1A) und die Speisespannung ($U_s$) bestimmt ist, sodass R1A $\approx$ US/$I_{K1}$.

4. Stromversorgung nach einem der Ansprüche 1 bis 3, **dadurch gekennzeichnet, dass** die Halbleiterschalter (SW1, H1A) vom FET-Typ sind.

5. Stromversorgung nach Anspruch 4, **dadurch gekennzeichnet, dass** die Halbleiterschalter (SW1, H1A) vom selbstsperrenden FET-Typ sind, wobei das Gate des Haupt-Halbleiterschalters (SW1) mit der Source verbunden und von einem Ausgang der Überwachungseinheit (UWE) über eine Zenerdiode (ZD1) und das Gate des Hilfs-Halbleiterschalters (H1A) von dem selben Ausgang direkt angesteuert ist.

6. Stromversorgung nach einem der Ansprüche 1 bis 5, **dadurch gekennzeichnet, dass** der Ballastwiderstand (R1A) als Massewiderstand ausgebildet ist.

## Claims

1. Power supply with which a supply voltage ($U_s$) is supplied through at least one longitudinal branch to at least one output, with the at least one branch having a cut-off device designed as a controlled semiconductor switch (SW1) and a monitoring unit(UWE) which is designed to supply a cut-off signal (s1) to the semiconductor switch in the event of changes in the voltages or currents beyond pre-settable tolerance values,
   **characterized in that**
   at least one series circuit of an auxiliary semiconductor switch (H1A), likewise controlled by the monitoring unit (UWE), and a ballast resistor (R1A) are connected in parallel with the semiconductor switch (SW1), with the gate voltage of the semiconductor switch (SW1) being reduced in the event of overload, so that the semiconductor switch (SW1) is no longer saturated and the auxiliary semiconductor switch (H1A) accepts a main proportion of the overload current in the branch.

**2.** Power supply according to Claim 1, **characterized in that** the monitoring unit (UWE) is designed so that it holds the auxiliary conductor switch (H1A) at least essentially switched off during normal operation but in the event of an overload switches on the auxiliary semiconductor switch (H1A) and switches off the main semiconductor switch (SW1) at the same time.

**3.** Power supply according to Claim 1 or 2, **characterized in that** the pre-settable short-circuit current ($I_{K1}$) of the branch is essentially determined by the ballast resistor (R1A) and the supply voltage ($U_s$), so that R1A $\approx U_s/I_{K1}$ .

**4.** Power supply according to one of Claims 1 to 3, **characterized in that** the semiconductor switches (SW1, H1A) are of the FET type.

**5.** Power supply according to Claim 4, **characterized in that** the semiconductor switches (SW1, H1A) are of the self-blocking FET type, with the gate of the main semiconductor switch (SW1) being connected to the source and controlled from an output of the monitoring unit (UWE) via a zener diode (ZD1) and the gate of the auxiliary semiconductor switch (H1A) being directly controlled from the same output.

**6.** Power supply according to one of Claims 1 to 5, **characterized in that** the ballast resistor (R1A) is designed as a composition resistor.

**Revendications**

**1.** Alimentation en courant, dans laquelle une tension ( $U_s$ ) d'alimentation est appliquée par au moins une branche longue à au moins une sortie, la au moins une branche ayant une sécurité d'interruption constituée sous la forme d'un commutateur ( SW1 ) commandé à semi-conducteur et une unité ( UWE ) de contrôle est montée de façon à fournir, lorsqu'il se produit des variations de tension ou de courant au-delà de valeur de tolérance pouvant être prescrite, un signal ( s1 ) de blocage au commutateur à semi-conducteur,

**caractérisée en ce que**

au moins un circuit série d'un commutateur ( H1A ) auxiliaire à semi-conducteur, commandé également par l'unité ( UWE ) de contrôle, et d'une résistance ( R1A ) de ballast est monté en parallèle au commutateur ( SW1 ) à semi-conducteur, dans lequel, dans le cas d'une surcharge, la tension de grille du commutateur ( SW1 ) à semi-conducteur est réduite de sorte que celui-ci quitte la saturation et le commutateur ( H1A ) à semi-conducteur auxiliaire prend en charge une proportion sensible du courant de surcharge dans la branche.

**2.** Alimentation en courant suivant la revendication 1, **caractérisée en ce que** l'unité ( UWE ) de contrôle est telle qu'elle maintient le commutateur ( H1A ) auxiliaire à semi-conducteur en fonctionnement normal au moins sensiblement à l'état bloqué mais, en cas de surcharge, le met à l'état passant, tout en bloquant simultanément le commutateur ( SW1 ) principal à semi-conducteur.

**3.** Alimentation en courant suivant la revendication 1 ou 2, **caractérisée en ce que** le courant ( $I_{K1}$ ) de court-circuit, pouvant être prescrit de la branche, est déterminé essentiellement par la résistance ( R1A ) du ballast et par la tension ( $U_s$ ) d'alimentation de sorte que R1A $\approx U_s/I_{K1}$ .

**4.** Alimentation en courant suivant l'une des revendications 1 à 3, **caractérisée en ce que** les commutateurs ( SW1, H1A )à semi-conducteur sont du type FET.

**5.** Alimentation en courant suivant la revendication 4, **caractérisée en ce que** les commutateurs ( SW1, H1A ) à semi-conducteur sont du type FET à auto-blocage, la grille du commutateur ( SW1 ) principal à semi-conducteur étant reliée à la source et étant commandée directement par une sortie de l'unité ( UWE ) de contrôle, par l'intermédiaire d'une diode ( ZD1 ) Zener et la grille du commutateur ( H1A ) auxiliaire à semi-conducteur étant commandée directement par la même sortie.

**6.** Alimentation en courant suivant l'une des revendications 1 à 5, **caractérisée en ce que** la résistance ( R1A ) de ballast est constituée en résistance de masse.

Fig. 1

Fig. 2

Fig. 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- AT 0000318 W
- DE 29909206 U1

- US 5969514 A